# EUROPEAN PATENT SPECIFICATION

(11) **EP 1 979 758 B1**
(45) Date of publication and mention of the grant of the patent: **15.07.2009**
(21) Application number: 06828477.7
(22) Date of filing: 21.12.2006
(51) Int. Cl.: G01R 31/3193, H04L 1/06, B61L 7/06, B61L 21/06

(54) **METHOD FOR A ONE-TIME CALIBRATION OF A MULTIPLE BRANCHES DIGITAL MEASUREMENT SYSTEM WORKING IN MINIMUM NUMBER OF BRANCHES MODE**
VERFAHREN ZUR EINMALIGEN KALIBRATION EINES IM MODUS DER MINIMALEN ANZAHL VON ABZWEIGUNGEN ARBEITENDEN MEHRFACHABZWEIGUNGS-DIGITALMESSSYSTEMS
PROCÉDÉ DE CALIBRAGE EN UNE SEULE FOIS D'UN SYSTÈME DE MESURE NUMÉRIQUE À PLUSIEURS BRANCHES FONCTIONNANT DANS UN MODE À NOMBRE MINIMUM DE BRANCHES

(30) Priority: 26.01.2006 CZ 20060058
(43) Date of publication of application: 15.10.2008
(73) Proprietor: AZD Praha S.R.O., 106 17 Praha 10 (CZ)
(72) Inventor: FARAN, Antonín, 141 00 Praha 4 (CZ); MLNARIK, Karel, 280 04 Kolin 4 (CZ); SRB, Stanislav, 150 00 Praha 6 (CZ); BUKAC, Pavel, 280 05 Kolin 5 (CZ); DOBIAS, Radek, 190 00 Praha 9 (CZ)
(74) Representative: Smrckova, Marie
(86) International application number: PCT/CZ2006/000095
(87) International publication number: WO 2007/085208

(56) References cited:
- EP-A- 0 704 365
- GB-A- 1 359 748
- US-A- 3 681 578
- US-A- 4 284 256
- US-A- 5 577 199

## Description

### Technical Field

The invention concerns the method for a one-time calibration of a digital measurement system working in the mode of the minimum number of branches from all possible branches, which is part of the railway signalling equipment.

### Background of the Invention

So far an automatic method for a one-time calibration of a digital measurement system has not been resolved in railway signalling technology. Until now a solution, where it is necessary to manually carry out the regular periodic calibration of each branch of the measurement system by measuring and adjusting has been used. This is disadvantageous, because this method is relatively laborious and expensive since the influence of the human factor is asserted adversely during these stereotypical periodical activities.

GB 1,359,748 describes a data processing system, including three similar digital computers, to which the same input data is transferred simultaneously. This system comprises a common supervisory and output device, to which the outputs of the computers are delivered simultaneously. Each of the computer outputs comprises a series of data message. Each message comprises an information part and test part. Each message is delivered serially to the supervisory and output device. The supervisory and output device comprises means for comparing the three outputs, means for determining - when an output is in error, means for selecting two of the outputs - that are not in error, means for deriving from the two error free outputs a series of data messages, corresponding to the error free outputs for delivery to transmission channel.

The data processing system further can the means for comparing. These means comprise three comparators, each of which compares the outputs of different pair of computers, also the means for deriving, includes a control means, responsive to the outputs of the three comparators to control the connecting means.

The outputs of the computers are connected to a supervisory and output device, via transmission channels, can be selectively connected to the outputs of the computers.

Supervisory and output system compares and evaluates output data according size of actual valuation.

Disadvantage of the data processing system is that system evaluates the measured value very intricately and slowly by help the supervisory and output device. Problem can arise at the time of evaluation of measured value with the required tolerance, on which the supervisory and output device need not to correspond. Drawback lies in a limitation only for three computers, when in operation is the more computers. System needs also generator of clock pulses. Relatively complicated solution presents also an allocation of measured value.

US patent 5,577,199 describes a majority circuit, a controller and majority LSI. a majority arrangement, which consist of X (X>=3) number of n-bit (n>= 2) signal from X number of systems and for outputing one of the n-bit signals as a majority signal. The n-bit signals, as input signals, are compared by help Y (X>Y>= 2) compare means. The majority circuit comprising the compare means, the select means, the error recognition means and the window means. System can contain also the interrupt means.

The invention provides a majority circuit, connecting a plurality of processing units. The majority circuit can detect the single errors or multiple errors, and sets the majority output signal to an ineffective level, when multiple errors are detected. The majority circuit includes comparators, each comparing two outputs of three processing units, and the error detector recognizes the error status and outputs the single error signal and the multiple error signal accordingly. The majority circuit also includes a selector, which selects the output of a normal processing unit, when the normal processing unit can be specified based on the comparison result. The selector changes the output to a predetermined level, when normal processing unit cannot be specified.

A disadvantage of the majority system is rather an complicated majority circuit, a necessity of means as is selector, error detector, window circuit, comparators, i.e. intricate hardware, what can present to a easy failure rate and a lower inherent reliability. Inadvisability can be in evaluation of measured value with respect of required tolerance. The certain disadvantage can be also a connection, providing a control signal, showing on validity of signal from system. Majority circuit contains subsidiary subsystems, which can fail and safe.

Majority system as such is characterized by "voting" Y from X possibility or channel about valuation of input signals. It is can be inconvenient, because it can be hardly happen to a congruence of an evaluated value with respect of its predetermined tolerance.

The both cited solutions appraise the value of measured of voltage, with un-recognized tolerance, what can be a source of system instability.

### Summary of Invention

The aforementioned disadvantages of the solution that is currently known is removed or substantially limited by this method for a one-time calibration of a digital measurement system, working in the mode of the minimum number of branches from all possible branches pursuant to this invention, the essence of which consists in that the first input evaluated voltage is supplied identically on the first input of the first possible branch, on the first input of the second possible branch to the first input of the last possible branch. In the first step each branch from the set of the first possible branch, second possible branch to the last possible branch stores, consecutively, the sequence of partial immediate information, having a high information capacity about the first evaluated voltage (i.e. the first possible partial information), from each branch's respective first output (i.e. from the first output of the first possible branch, the first output of the second possible branch to the first output of the last possible branch), through the input bus to the determined partial raster, divided into the entered number pursuant to the nth order number of the consecutively structured areas, starting with the first structured area, second structured area to the last possible structured area; it further stores the second possible partial information, until it stores the last possible partial information together with the first order number of the first structured area, with the second order number of the second structured area to the nth order number of the last possible structured area of the determined partial raster. Whereas in the second step the comparator, on the basis of a comparison of the respective pairs of partial immediate information of the individual branches, evaluates the result of the comparison so that, when the immediate values of two units of partial information of two branches from the set of the first possible branch, second possible branch to the last possible branch are in the same identical area, i.e. in either the same first area, in the same second area up to in the same nth area, or if their first order number, second order number to nth order number differ at most by a value of one then the digital measuring system declares, through the output of the comparator, the correctness of the evaluated voltage by its first logical correct output unit.

The one-time calibration of the measurement system is only performed in the structures of the fixed programmable memory of each digital measurement system on all its possible branches when being manufactured or during the reconstruction of the relevant signalling equipment. The correct status of the once-performed calibration is controlled during the remainder of the technical life of the signalling equipment without the influence of a human factor in accordance with the entered algorithm by repeating automatic measurements according to this invention, where it is based on the assumption that a disruption of the measurement system's data, e.g. the entry sensitivity, will only occur in one of all the possible branches of the measurement system at one time.

The main advantage of the method of the one-time calibration of the digital measurement system working in the mode of the minimum number of branches of all the possible branches consists in the fact that the objective automatic calibration is performed for secure measurement system applications without the negative influence of a human factor.

Great advantage of proposal method is its unpretentiousness, lies also in a small number of the needed components and from which resulting the high inherent reliability, unicity and exactness of evaluation with predetermined tolerance, given by the selection of numbers of the structured areas. This one-time calibration is quick and easy for servicing staff. The system is basically maintenance-free from above cited reasons.

### Brief Description of Drawings

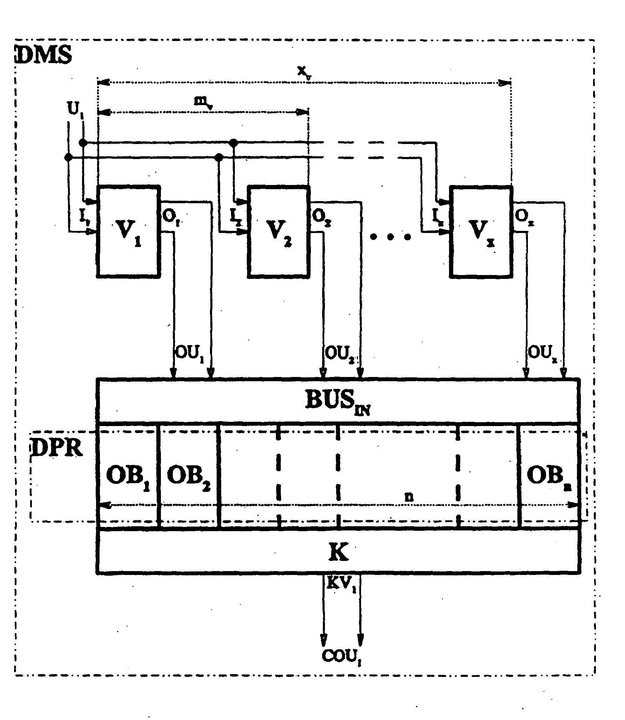

The invention is described in detail in an exemplary fashion, clarified with the generalised schematic diagram on the attached drawing.

### Detailed Description of the Invention's Preferred Embodiments

The method of the one-time calibrations of the digital measurement system **DMS,** working in the mode of the minimum possible branches **mᵥ** from all the possible branches **xᵥ** is apparent from the generalised schematic diagram of the version from which it is apparent, that the first evaluated voltage ***U₁** is supplied* identically on the first input **I₁** of the first possible branch **V₁,** on the first input **I₂** of the second possible branch **V₂** to the first input **I_{X}** of the last possible branch **V_{X}** with the subsequent calibration being performed in two steps.

In the first step each branch from the set of the first possible branch **V₁,** second possible branch **V₂** to the last possible branch **V_{X}** *stores,* consecutively, the sequence of partial immediate information, having a high information capacity about the first evaluated voltage **U₁** (i.e. the first possible partial information ***OU₁)*,** from each branch's respective first output (i. e. from the first output **O₁** of the first possible branch **V₁,** the first output O₂ of the second possible branch **V₂** to the first output **O_{X}** of the last possible branch ***V_{X}*)** through the input bus **BUS_{IN}** to the determined partial raster **DPR,** divided into the entered number pursuant to the nth order number **nₙ** of the consecutively structured areas, starting with the first structured area **OB₁,** second structured area **OB₂** to the last possible structured area **OBₙ;** it further *stores* the second possible partial information **OU₂,** until it *stores* the last possible partial information **OU_{X}** together with the first order number **n₁** of the first structured area **OB₁,** with the second order number **n₂** of the second structured area **OB₂** to the nth order number **nₙ** of the last possible structured area **OBₙ** of the determined partial raster **DPR.**

In the second step the comparator **K,** on the basis of a comparison of the respective pairs of partial immediate information of the individual branches, *evaluates* the result of the comparison so that, when the immediate values of two units of partial information of two branches from the set of the first possible branch **V₁,** second possible branch **V₂** to the last possible branch **V_{X}** *are in the same identical area*, i.e. in either the same first area **OB₁,** in the same second area **OB₂** up to in the same nth area **OBₙ,** or if their first order number **n₁,** second order number **n₂** to nth order number **nₙ** *differ at most by a value of one*, then the digital measuring system **DMS** *declares*, through the output **KV₁** of the comparator **K,** the *correctness* of the evaluated voltage **U₁** by its first logical correct output unit **COU₁.**

The pairs of possible partial information **OU₁, OU₂ - OU_{X},** corresponding with evaluation of the first evaluated voltage **U1,** are compared by conjunctive manner during one-time calibration. The possible partial information **OU₁, OU₂ - OU_{X}** are assigned, according the size, to the order number n₁- nₙ, according the consecutively partial structured areas **OB₁, OB₂ - OBₙ,** which have the high testified ability about the first evaluated voltage **U1.** Tolerance of the measured quantity is given by values of two adjacent consecutively partial structural areas **OB₁, OB₂ - OBₙ,** because in its, the actual partial information **OU₁, OU₂ - OU_{X}** are stored according its size. Therefore, the explicit and quick congruency is acquired during evaluation of these actual partial information **OU₁, OU₂ - OU_{X}.** The once used comparator **K** merely selects only one from the consecutively partial structural areas **OB₁, UB₂ - OBₙ ,** and evaluates the measured value discreetly.

Calibration according to invention can be executed only one-times, and it need not be repeated even several of the years, as necessary.

### Industrial Applicability

The method of the one-time calibration of the digital measurement system according to this invention can be used both for the new construction of railway signalling equipment and for innovations to existing signalling equipment as long as electronic devices are introduced in these cases. The invention can also be used anywhere where the calibration of a digital measurement system is to be performed in the sense of CSN EN (Czech/European Norm) 50 129.

### List of Relational Symbols

- DMS: Digital Measurement System
- mᵥ: Minimum Number of Branches
- xᵥ: All Possible Branches
- I₁: First Input of the First Possible Branch V₁
- I₂: First Input of the Second Possible Branch V₂
- I_{X}: First Input of the Last Possible Branch V_{X}
- V₁: First Branch
- V₂: Second Branch
- V_{X}: Last Possible Branch
- U₁: First Evaluated Voltage
- O₁: First Output of the First Possible Branch V₁
- O₂: First Output of the Second Possible Branch V₂
- O_{X}: First Output of the Last Possible Branch V_{X}
- BUS_{IN}: Input Bus
- DPR: Determined Partial Raster
- nₙ: nth Order Number of the nth consecutively Structured Area OBₙ
- n₁: First Order Number of the First Area OB₁
- n₂: Second Order Number of the Second Area OB₂
- OB₁: First Area
- OB₂: Second Area
- OBₙ: nth Area
- OU₁: First Possible Partial Information
- OU₂: Second Possible Partial Information
- OU_{X}: Last Possible Partial Information
- K: Comparator
- KV₁: Output of Comparator K
- COU₁: Logical Correct Output Unit of Comparator K

## Claims

1. The method of the calibration of a digital measurement system (DMS) working in the mode of the minimum number of branches (mᵥ) from all possible branches (xᵥ),
the first evaluated voltage (U₁) *is supplied* identically on the first input (I₁₁) of the first possible branch (V₁), on the first input (I₂₁) of the second possible branch (V₂) to the first input (I_{X1}) of the last possible branch (V_{X}),
is **characterised by** the fact **that:**
- in the first step, each branch from the set of the first possible branch (V₁), second possible branch (V₂) to the last possible branch (V_{X}), stores, consecutively, the sequence of partial immediate information, having a high information capacity about the first evaluated voltage (U₁),i.e. the first possible partial information (OU₁), from each branch's respective first output, i.e. from the first output (O₁ of the first possible branch (V₁), the first output (O₂) of the second possible branch (V₂) to the first output (O_{X}) of the last possible branch (V_{X})) through the input bus (BUS_{IN}) to the determined partial raster (DPR), divided into the entered number pursuant to the nth order number (nₙ) of the consecutively structured areas, starting with the first structured area (OB₁), second structured area (OB₂) to the last possible structured area (OBₙ); it further *stores* the second possible partial information (OU₂), until it *stores* the last possible partial information (OU_{X}) together with the first order number (n₁) of the first structured area (OB₁), with the second order number (n₂) of the second structured area (OB₂) to the nth order number (nₙ) of the last possible structured area (OBₙ) of the determined partial raster (DPR) and
- whereas in the second step the comparator (K), on the basis of a comparison of the respective pairs of partial immediate information of the individual branches, evaluates the result of the comparison so that, when the immediate values of two units of partial information of two branches from the set of the first possible branch (V₁), second possible branch (V₂) to the last possible branch (V_{X}) are in the same identical area, i.e. in either the same first area (OB₁), in the same second area (OB₂) up to in the same nth area (OBₙ), or if their first order number (n₁), second order number (n₂) to nth order number (nₙ) differs at most by a value of one,
- then the digital measuring system (DMS) declares, through the output (KV₁) of the comparator (K), the correctness of the evaluated voltage (U1) by its first logical correct output unit (COU₁).

## Patentansprüche

1. Das Verfahren zur einmaligen Kalibration eines im Modus der minimalen Anzahl von Abzweigungen (mᵥ) arbeitenden Mehrfachabzweigungs-Digitalmesssystems (DMS), von allen möglichen Abzweigungen (xᵥ), wo zum ersten Input (I₁) der ersten möglichen Abzweigung (V₁), zum ersten Input (I₁) der zweiten möglichen Abzweigung (V₂) bis zum ersten Input (Iₓ₁) der letzten möglichen Abzweigung (Vₓ) kongruent zugeleitet wird die erste zu ermittelnde Spannung (U₁),
wird **dadurch gekennzeichnet, dass**
- im ersten Schritt, durch jede Abzweigung aus der Menge der ersten möglichen Abzweigung (V₁), der zweiten möglichen Abzweigung (V₂), bis hin der letzten möglichen Abzweigung (Vₓ) von deren jeweiligem ersten Output, d.h. vom ersten Output (O₁) der ersten möglichen Abzweigung (V₁), vom ersten Output (O₂) der zweiten möglichen Abzweigung (V₂), bis hin vom ersten Output (Oₓ) der letzten möglichen Abzweigung (Vₓ), konsequent über die Input Sammelschiene (BUS_{IN}) gepuffert wird in vordefinierten partiellen Raster (DPR), der geteilt ist gemäss n-ter (Date-) Folgenummer (nₙ) auf die vordefinierte Anzahl konsequent strukturierter *(gegliederter)* Bereiche, angefangen von erstem strukturiertem Bereich (OB₁), zweitem strukturiertem Bereich (OB₂), bis hin letztem möglichen strukturiertem Bereich (OBₙ), die Folge sofortiger partieller Informationen, die hoch aussagekräftig ist über die erste zu ermittelnde Spannung (U₁), d.h. die die erste mögliche partielle Information (OU₁) trägt; ferner werden die zweite mögliche partielle Information (OU₂), bis hin die letzte mögliche partielle Information (OU_{X}) gepuffert, gleichzeitig mit erster (Daten-) Folgenummer (n₁) des ersten strukturierten Bereiches (OB₁), mit zweiter (Daten-) Folgenummer (n₂) des zweiten strukturierten Bereiches (OB₂), bis hin mit n-ter (Daten-) Folgenummer (nₙ) des letzten möglichen strukturierten Bereiches (OBₙ) über den vordefinierten partiellen Raster (DPR),
- wobei im zweiten Schritt ermittelt wird durch den Komparator (K) auf Grund des Vergleiches vom entsprechenden Paar sofortiger partieller Informationen aus der einzelnen Abzweigungen das Komparationssresultat mittels des Verfahrens, in dem die sofortigen Werte zwei partieller Informationen über zwei Abzweigungen aus der Menge der ersten möglichen Abzweigung (V₁), der zweiten möglichen Abzweigung (V₂), bis hin der letzten möglichen Abzweigung (Vₓ), in einem gleichen Bereich, d.h. entweder in gleichem erstem Bereich (OB₁), gleichem zweitem Bereich (OB₂), bis hin n-tem Bereich (OBₙ), sind, oder in dem deren erste (Daten-) Folgenummer (n₁), zweite (Daten-) Folgenummer (n₂), bis hin n-te (Daten-) Folgenummer (nₙ) höchstens um den Wert eins differenziert werden;
- daher zeigt *(deklariert)* das Digitalmesssystem (DMS) über den Output (KV₁) des Komparators (K) mittels dessen ersten korrekten logischen Einheits-Outputs (COU₁) die Korrektheit der zu ermittelnden Spannung (U1) an.

## Revendications

1. Procédé de calibrage ponctuel d'un système de mesure numérique (SMN [DMS]) à plusieurs branches fonctionnant dans un mode à nombre minimal de branches (mᵥ) à partir de toutes les branches possibles (xᵥ), où, sur la première entrée (I₁) de la première branche possible (V₁), sur la première entrée (I₁) de la deuxième branche possible (V₂) jusqu'à la première entrée (Iₓ₁) de la dernière branche possible (Vₓ), est amenée la première tension évaluée identique (U₁),
**se caractérisant par le fait**
- **qu'**à la première étape, chacune des branches de l'ensemble de la première branche possible (V₁), de la deuxième branche possible (V₂), jusqu'à la dernière branche possible (Vₓ), à partir de chacune de leur première sortie respective, à savoir de la première sortie (O₁) de la première branche possible (V₁), de la première sortie (O₂) de la deuxième branche possible (V₂), jusqu'à la première sortie (Oₓ) de la dernière branche possible (Vₓ), stocke de manière concordante, par l'intermédiaire de l'omnibus d'entrée (BUS_{IN}) dans le rastre partiel déterminé (RPD [DPR]), divisé en nombre demandé selon le numéro d'ordre n (nₙ) de zones structurées de manière concordante, à commencer par la première zone structurée (OB₁), la deuxième zone structurée (OB₂), jusqu'à la dernière zone structurée possible (OBₙ), une suite d'informations immédiates partielles, ayant une capacité de témoignage élevée concernant la première tension évaluée (U₁), par conséquent la première information partielle possible (OU₁), et, par ailleurs, stocke la deuxième information partielle possible (OU₂), jusqu'à la dernière information partielle possible (OU_{X}) de manière concomitante avec le premier numéro d'ordre (n₁) de la première zone structurée (OB₁), avec le deuxième numéro d'ordre (n₂) de la deuxième zone structurée (OB₂), jusqu'au numéro d'ordre n (nₙ) de la dernière zone structurée possible (OBₙ) du rastre partiel déterminé (RPD [DPR]),
- tandis que dans la deuxième étape, le comparateur (K) évalue sur la base d'une comparaison du couple correspondant d'informations immédiates partielles de chaque branche le résultat de la comparaison, de façon à ce que, lorsque les valeurs immédiates de deux informations partielles de deux branches de l'ensemble de la première branche possible (V₁), de la deuxième branche possible (V₂), jusqu'à la dernière branche possible (Vₓ), sont dans la même seule zone, à savoir soit dans la même première zone (OB₁), soit dans la même deuxième zone (OB₂), soit jusque dans la même zone n (OBₙ), ou lorsque leur premier numéro d'ordre (n₁), deuxième numéro d'ordre (n₂), jusqu'au numéro d'ordre (nₙ) se différencient au plus par la valeur un,
- le système de mesure numérique (SMN) déclare alors par l'intermédiaire de la sortie (KV₁) du comparateur (K) le caractère correct de la tension évaluée (U1) par sa première sortie correcte logiquement unitaire (COU₁).
